# EUROPÄISCHE PATENTSCHRIFT

(11) **EP 3 250 731 B1**
(45) Veröffentlichungstag und Bekanntmachung des Hinweises auf die Patenterteilung: **26.12.2018**
(21) Anmeldenummer: 16720081.5
(22) Anmeldetag: 25.04.2016
(51) Int. Cl.: C23C 24/10, B23K 26/144, C23C 4/12

(54) **LASERBESCHICHTUNGSVERFAHREN UND VORRICHTUNG ZU DESSEN DURCHFÜHRUNG**
LASER COATING PROCESS AND DEVICE THEREFOR
PROCÉDÉ DE REVÊTEMENT AU LASER ET DISPOSITIF POUR SA MISE EN UVRE

(30) Priorität: 27.04.2015 DE 102015106464
(43) Veröffentlichungstag der Anmeldung: 06.12.2017
(73) Patentinhaber: Plasma Innovations GmbH, 4800 Attnang-Puchheim (AT); ECKART GmbH, 91235 Hartenstein (DE)
(72) Erfinder: BISGES, Michael, 93049 Regensburg (DE); HIRTH, Ulrich-Andreas, 95445 Bayreuth (DE)
(74) Vertreter: Kohlmann, Kai
(86) Internationale Anmeldenummer: PCT/EP2016/059126
(87) Internationale Veröffentlichungsnummer: WO 2016/173963

(56) Entgegenhaltungen:
- EP-A1- 2 774 714
- DE-A1- 19 606 383

## Beschreibung

Die Erfindung betrifft ein Verfahren und eine Vorrichtung zum Aufbringen eines nahezu beliebigen festen Beschichtungsmaterials auf einer Oberfläche.

Aus dem Stand der Technik ist das Laserauftragschweißen bekannt, bei dem auf einer Nerkstückoberfläche ein Oberflächenauftrag durch Aufbringen eines nahezu beliebigen Beschichtungsmaterials aufgebracht wird. Ein Laserstrahl erzeugt ein Schmelzbad auf der Bauteiloberfläche, der das Beschichtungsmaterial als Pulver-Gasgemisch mittels Düsen zugeführt wird. Das Beschichtungsmaterial ist insbesondere ein Metallpulver. Sowohl die Oberfläche des Bauteils als auch das Beschichtungsmaterial werden beim Laserauftragschweißen aufgeschmolzen.

Eine aus dem Prospekt "Laserauftragschweißen: Oberflächen optimieren und reparieren.-Ident-Nr. 0375845_201306_F" der Firma Trumpf Laser- und Systemtechnik GmbH, D 71254 Ditzingen offenbarte Vorrichtung zum Laserauftragschweißen weist einen Pulverförderer zum Bereitstellen eines Pulver-Gasgemischstroms sowie eine Bearbeitungsoptik mit Pulverdüse auf. Mit Hilfe der Pulverdüse wird der zuvor von dem Pulverförderer bereitgestellte Pulver-Gasgemischstrom der zu beschichtenden Oberfläche zugeführt. Die Bearbeitungsoptik weist als Strahlquelle einen Scheiben- oder Diodenlaser auf. Die Bearbeitungsoptik ist derart ausgerichtet, dass der Laserstrahl auf die Oberfläche des Werkstückes trifft, auf die der Pulver-Gasgemischstrom gerichtet ist.

Das Laserauftragschweißen ist nur für bestimmte Oberflächen geeignet. Insbesondere bei Kunststoffen führt die hohe, in die Bauteiloberfläche eingekoppelte Energie des Laserstrahls zu einer Beschädigung der Bauteiloberfläche. Das Laserauftragschweißen ist daher nur auf Oberflächen von hochschmelzenden Kunststoffen, Metallen oder Keramiken möglich.

Die DE 19606 383 A1 offenbart eine Vorrichtung zum Aufbringen eines Beschichtungsmaterials auf eine Oberfläche eines Substrates, bei der ein Pulverbeschlchtungsstrom in einen Pulverauftragskopf geführt wird. In diesem Pulverauftragskopf durchläuft der Pulverbeschichtungsstrom eine Schmelzzone. Der aus dem Auftragskopf austretende Beschichtungspulverstrom breitet sich in Richtung des Substrates aus und bildet auf dessen Oberfläche eine Schicht aus Beschichtungspulver aus, wenn der Pulverauftragskopf relativ zum Substrat bewegt wird. Zum Schmelzen des Beschichtungspulvers in der Schmelzzone ist ein Laserstrahl vorgesehen. Der Laserstrahl tritt aus dem Laser in den Pulverauftragskopf ein und wird von einer Strahlführungsoptik so geführt, dass der Laserstrahl in der Schmelzzone den Beschichtungspulverstrom quer zu seiner Durchlaufrichtung mehrfach durchsetzt. Beim Verlassen der Schmelzzone ist das Beschichtungspulver aufgeschmolzen. Mit der bekannten Vorrichtung wird das Ziel verfolgt, dass das Beschichtungspulver vor dem Auftreffen auf dem Substrat vollständig aufgeschmolzen ist.

Ausgehend von diesem Stand der Technik liegt der Erfindung die Aufgabe zugrunde, ein Verfahren zum strukturierten Aufbringen pulverförmiger fester Beschichtungsmaterialien auch auf temperaturempfindlichen Oberflächen zu schaffen, welches zudem deutlich weniger Energie benötigt. Außerdem soll eine vorteilhafte Vorrichtung zur Durchführung des Verfahrens angegeben werden.

Diese Aufgabe wird durch ein Verfahren mit den Merkmalen des Anspruchs 1 und eine Vorrichtung mit den Merkmalen des Anspruchs 21 gelöst.

Das Einkoppeln des mindestens einen Laserstrahls in den Gasgemischstrom erfolgt vorzugsweise unmittelbar vor dem Auftreffen des Gasgemischstroms auf die Oberfläche. Durch das Einkoppeln wird die Energie von dem Laserstrahl auf das als Feststoff vorliegende Beschichtungsmaterial in dem Gasgemischstrom übertragen, wobei die eingekoppelte Energie des mindestens einen Laserstrahls derart bestimmt wird, dass das feste Beschichtungsmaterial zumindest teilweise schmilzt.

Jeder Laserstrahl wird derart auf den Gasgemischstrom ausgerichtet, dass der Laserstrahl den Auftreffbereich des auf der Oberfläche aufgebrachten Beschichtungsmaterials nicht trifft. Hierdurch wird bewirkt, dass die Energie des Laserstrahls nicht unmittelbar auf die Oberfläche übertragen und die thermische Belastung der Oberfläche gegenüber dem Laserauftragschweißen erheblich reduziert wird. Die geringere Wärmebelastung der Oberfläche erlaubt die Beschichtung wärmeempfindlicher Materialien mit dem erfindungsgemäßen Verfahren. Vorzugsweise wird jeder Laserstrahl derart zur Oberfläche ausgerichtet, dass der Laserstrahl an keiner Stelle die Oberfläche trifft. Dies kann beispielsweise durch eine parallele oder nach oben geneigte Ausrichtung des Laserstrahls zur Oberfläche erreicht werden.

Das als Feststoff in dem Gasgemischstrom vorliegende Beschichtungsmaterial wird ausschließlich durch die eingekoppelte Energie des mindestens einen Laserstrahls teilweise geschmolzen. Der Beschichtungsprozess lässt sich daher allein mit Hilfe des Lasers bzw. der Laser steuern, beispielsweise durch Abschalten der Laserleistung, Ausblenden des Laserstrahls oder durch Ablenken des Laserstrahls derart, dass er zeitweilig nicht auf den Gasgemischstrom ausgerichtet ist. Zumindest die Oberfläche der Partikel des festen Beschichtungsmaterials wird durch die eingekcppelte Energie des mindestens einen Laserstrahls geschmolzen, um eine haftfeste Beschichtung zu erzeugen.

Ein strukturiertes Aufbringen des Beschichtungsmateriales auf die Oberfläche kann auf einfache Art und Weise dadurch erfolgen, dass während des Zuführens des Gasgemischstroms das Einkoppeln des mindestens einen Laserstrahls zeitweilig unterbrochen wird. Hierdurch wird die Energieübertragung auf das Beschichtungsmaterial zeitweilig unterbunden und dadurch das während der Unterbrechung zugeführte Beschichtungsmaterial nicht aufgeschmolzen. In Verbindung mit einer Relativbewegung zwischen der Oberfläche und dem Gasgemischstrom können durch das Unterbrechen des Einkoppelns Bereiche auf der Oberfläche geschaffen werden, in denen das Beschichtungsmaterial nicht anhaftet.

Zur zeitweiligen Unterbrechung des Einkoppelns kann die Laserleistung abgeschaltet, der Laserstrahl mit einer Blende ausgeblendet oder durch eine Laseroptik derart abgelenkt werden, dass er zeitweilig nicht auf den Gasgemischstrom ausgerichtet ist.

Durch die unmittelbare Einkopplung des Laserstrahls in den Gasgemischstrom und das nicht erforderliche Aufschmelzen der Oberfläche des Bauteils ist die benötigte Laserleistung des erfindungsgemäßen Verfahrens gegenüber dem Laserauftragsschweißen erheblich geringer. Um einen Massestrom eines Beschichtungsmaterials (Kupfer) von beispielsweise 10 g/min ausschließlich mit Hilfe der Laserstrahlung derart aufzuschmelzen, dass eine Anhaftung beispielsweise an einer Kunststoffoberfläche oder an einer zuvor abgeschiedenen Schicht des Beschichtungsmaterials eintritt, genügt bereits eine Laserleistung von 10 Watt.

Erfindungsgemäß wird das Beschichtungsmaterial großflächig aufgebracht. Für eine großflächige Beschichtung mit einem Auftreffbereich des aufgebrachten Beschichtungsmaterials, der größer ist als der Querschnitt des Gasgemischstroms, werden die Oberfläche und der Gasgemischstrom während des Aufbringens relativ zueinander bewegt. Die Relativbewegung kann durch Bewegen der zu beschichtenden Oberfläche und/oder durch Bewegung des Zuführorgans für den Gasgemischstrom erzeugt werden.

Der insbesondere von einem Pulverförderer bereit gestellte Gasgemischstrom umfasst das feste Beschichtungsmaterial. Als Beschichtungsmaterialien kommen insbesondere reine Metalle oder Legierungen zur Herstellung von elektrisch oder thermisch leitfähigen Beschichtungen zum Einsatz. Darüber hinaus eignet sich das Verfahren jedoch auch zum Aufbringen von Kunststoffen, Glas oder Keramik als Beschichtungsmaterialien. Die Beschichtungsmaterialien liegen als Pulver vor. Um die Energie der Laserstrahlung wirksam in die Beschichtungsmaterialien einzukoppeln muss die Wellenlänge der Laserstrahlung auf das Absorptionsspektrum des Beschichtungsmateriales abgestimmt sein.

Die Oberfläche, auf die das Beschichtungsmaterial aufgebracht wird, weist, sofern eine Anhaftung des aufgebrachten Beschichtungsmaterials angestrebt wird, vorzugsweise für das Beschichtungsmaterial haftvermittelnde Eigenschaften auf. Besonders vorteilhafte haftvermittelnde Materialien sind beispielsweise:
- Polyamid,
- PC-ABS (Polycarbonat Acrylnitril Butadien Styrol),
- PPS (Polyphenylensulfid)
- PBT (Polybutylenterephthalat),
- Duroplaste

Die vorstehenden Materialien können als reine Polymere oder als Compounds mit Füllstoffen vorliegen. Als Füllstoffe kommen beispielsweise Glas, Keramik oder, Metalle in Betracht. Maximal 30 Gewichtsprozente des Compounds sind Füllstoffe.

Um die Anhaftung des Beschichtungsmaterials auf der Oberfläche eines Gegenstandes zu verbessern, kann in vorzeilhafter Ausgestaltung der Erfindung zumindest die die Oberfläche aufweisende Decklage des Gegenstandes Hinterschneidungen aufweisen.

Der mindestens eine Laserstrahl wird erfindungsgemäß kontinuierlich mittels eines Dauerstrichlasers oder diskontinuierlich mittels eines Pulslasers erzeugt. Aufgrund der hohen Spitzenintensitäten kommt der Pulslaser insbesondere für Beschichtungsmaterialien mit höheren Schmelztemperaturen zum Einsatz.

Wird der mindestens eine Laserstrahl fokussiert in den Gasgemischstrom eingekoppelt, bewirkt die Bündelung der Strahlung eine hohe Energiedichte im Einkopplungsbereich. Mit einem defokussierten Laserstrahl lässt sich ein größerer Einkopplungsbereich in den Gasgemischstrom erzeugen.

Um den Einkopplungsbereich eines insbesondere fokussierten Laserstrahls in den Gasgemischstrom zu vergrößern, wird in einer Ausgestaltung der Erfindung während des Einkoppelns des mindestens eines Laserstrahls in den Gasgemischstrom die Ausrichtung des Laserstrahls verändert. Bei einem defokussierten Laserstrahl kann während des Einkoppelns des Laserstrahls in den Gasgemischstrom die Ausrichtung in der Regel unverändert beibehalten werden.

Das Bereitstellen des Gasgemischstroms umfassend das Trägergas und das feste Beschichtungsmaterial erfolgt mit Hilfe eines Pulverförderers. Der Pulverförderer umfasst als Fördereinrichtung beispielsweise einen Scheibenförderer, einen Vibrationsförderer oder eine Pulverpumpe, mit der das pulverförmige Beschichtungsmaterial in den Trägergasstrom eingebracht wird. Als Trägergas eignen sich insbesondere ein Inertgas, wie beispielsweise Argon, Stickstoff oder Umgebungsluft. Das Trägergas wird mit einem Volumenstrom im Bereich von l bis 50 l/min, vorzugsweise 1-20 l/min bereitgestellt. Die Fördereinrichtung des Pulverförderers führen dem Trägergas das Beschichtungsmaterial mit einem Massestrom im Bereich von 0,1 g/min bis 100 g/min, vorzugsweise 2 g/min bis 20 g/min zu. Das zugeführte pulverförmige Beschichtungsmaterial weist vorzugsweise eine Korngrößenverteilung von 100 nm bis 120 µm auf.

Der derart gebildete Gasgemischstrom wird über Leitungen zu einem Zuführorgan mit einem Auslass geführt, wobei der Auslass vorzugsweise in einem vertikalen Abstand im Bereich von 1 mm bis 100 mm zu der Oberfläche gehalten wird. Das Zuführorgan wird derart mit dem Auslass auf die Oberfläche ausgerichtet, dass der Gasgemischstrom vorzugsweise senkrecht auf die Oberfläche auftrifft.

Wird als Zuführorgan eine Hohlnadel verwendet, die einen Innendurchmesser im Bereich von 0,1 bis 10 mm aufweist, wird durch die im Verhältnis zum Innendurchmesser große Länge der Hohlnadel eine quasi-laminare Strömung des Pulver-Gasgemisches am Auslass erzeugt. Mit Hilfe des quasilaminaren Gasgemischstroms lassen sich präzise Strukturen auf der Oberfläche abscheiden.

Sollen breitere Spuren auf der Oberfläche abgeschieden werden, insbesondere für eine vollflächige Beschichtung, wird der Gasgemischstrom vorzugsweise über einen Diffusor zugeführt, der den Gasgemischstrom am Auslass beschleunigt und einen sich in Richtung des Auftreffbereichs erweiternden Gasgemischstrom erzeugt.

Der Laserstrahl wird vorzugsweise unmittelbar vor dem Auftreffen des Gasgemischstroms auf der Oberfläche in den Gasgemischstrom eingekoppelt, um die Energieverluste auf dem Weg vom Auslass des Zuführorgans zur Oberfläche gering zu halten. Je nach Abstand des Auslasses des Zuführorgans zur Oberfläche wird der Laserstrahl in den Gasgemischstrom in einem Abstand von 0,1 mm bis 50 mm oberhalb der Oberfläche eingekoppelt. Verändert sich der Abstand des Auslasses des Zuführorgans zu dem Auftreffbereich während des Aufbringens des Beschichtungsmaterials, wird vorzugsweise die Laserleistung bei größer werdendem Abstand erhöht und bei geringer werdendem Abstand abgesenkt.

Mit dem erfindungsgemäßen Verfahren lassen sich nicht nur strukturierte Beschichtungen auf einer Oberfläche aufbringen, sondern auch dreidimensionale Gegenstände als Oberflächenauftrag herstellen. Hierzu werden mehrere Lagen des Beschichtungsmaterials übereinander abgeschieden. Die jeweils zuvor abgeschiedene Lage bildet die Oberfläche, der im nächsten Arbeitsgang der Gasgemischstrom zugeführt wird. Die nacheinander abgeschiedenen Lagen können aus unterschiedlichem Beschichtungsmaterial bestehen. Beispielsweise können zunächst Einzellagen aus einem Polymer abgeschieden werden, auf die nachfolgend leitfähige Bahnen aus metallischem Beschichtungsmaterial, beispielsweise Kupfer, abgeschieden werden. Anschließend können weitere Lagen aus polymerem Beschichtungsmaterial aufgebaut werden, um ein komplexes Bauteil mit integrierter Leiterbahnstruktur zu erzeugen. Auf diese Weise lassen sich mit dem erfindungsgemäßen Verfahren Schaltungsträger aufbauen, die einem MID-Bauteil vergleichbar sind.

In einer Ausgestaltung des erfindungsgemäßen Verfahrens lässt sich eine Oberfläche strukturiert beschichten, indem vor dem Zuführen des Gasgemischstroms die Oberfläche teilweise mit einer Deckschicht versehen wird, die haftabweisende Eigenschaften gegenüber zugeführten Beschichtungsmaterial aufweist. Der Gasgemischstrom wird vorzugsweise mit aufgeweitetem Strömungsquerschnitt auf die Oberfläche gerichtet. Die Deckschicht bewirkt, dass sich das Beschichtungsmaterial ausschließlich mit den übrigen, nicht mit der Deckschicht versehenen Bereichen der Oberfläche haftfest verbindet. Die Oberfläche kann beispielsweise teilweise mit einer Deckschicht versehen werden, indem die zunächst vollflächig aufgetragene Deckschicht in Teilbereichen wieder abgetragen wird. Das Abtragen erfolgt beispielsweise im Wege der Laserablation, Deckschichten mit haftabweisenden Eigenschaften werden erfindungsgemäß in einer Schichtstärke von 1 µm bis 500 µm auf die Oberfläche aufgebracht.

Ein strukturiertes Aufbringen des Beschichtungsmaterials auf die Oberfläche kann in einer weiteren Ausgestaltung der Erfindung dadurch erreicht werden, dass das Substrat bzw. der Gegenstand Abschnitte mit haftvermittelnden und Abschnitte mit haftabweisenden Eigenschaften aufweist. Das auf die Oberfläche aufgebrachte Beschichtungsmaterial kann lediglich in denjenigen Abschnitten anhaften, die aus haftvermittelnden Materialien bestehen.

Ein strukturiertes Aufbringen des Beschichtungsmaterials auf die Oberfläche kann in einer weiteren Ausgestaltung der Erfindung dadurch erreicht werden, dass die Oberfläche oder der zu beschichtende Gegenstand zumindest abschnittsweise aus einem Opfermaterial besteht, wobei das Opfermaterial haftabweisende Eigenschaften gegenüber dem mit dem Gasgemischstrom anschließend zugeführten Beschichtungsmaterial aufweist. Aufgrund des Energieeintrags durch den Gasgemischstrom setzt das Opfermaterial gasförmige Bestandteile frei, die eine Anhaftung des Beschichtungsmaterials an der Oberfläche verhindert. Ein strukturiertes Aufbringen des Beschichtungsmaterials erfolgt, indem vor dem Aufbringen in Teilbereichen die aus Opfermaterial bestehende Oberfläche, z.B. mittels eines Lasers abgetragen bzw. passiviert wird. Durch das Abtragen wird eine unter dem Opfermaterial befindliche Oberfläche mit haftvermittelnden Eigenschaften freigelegt. Durch das Passivieren wird die aus dem Opfermaterial bestehende Oberfläche, ohne dass diese vollständig abgetragen wird, haftvermittelnd. Das Passivieren und Abtragen des Opfermaterials erfolgt durch gezielten Energieeintrag. Alternativ kann das Opfermaterial mittels Druckverfahren oder Maskierung schon strukturiert auf eine haftvermittelnde Oberfläche aufgebracht werden.

Das Opfermaterial, welches für die Herstellung einer Deckschicht oder eines Abschnitts eines Objektes verwendet werden kann, weist vorzugsweise mindestens eines der nachfolgenden Materialien auf:
- Polycarbonat,
- Polyacryl,
- UV-härtende Lacke die unter anderem Acrylatmonomere aufweisen.

Das Opfermaterial mit haftabweisenden Eigenschaften enthält vorzugsweise chemischen Substanzen, die eine *Acrylgruppe* (CH₂=CH-COR) aufweisen. Schon ab 1 Gewichtsprozent Anteil der Acrylgruppen in einem Polymer zeigen sich die haftabweisenden Eigenschaften des Opfermaterials.

Nachfolgend wird die Erfindung anhand der Figuren näher erläutert. Es zeigen:
- **Figur 1 A**: ein erstes Ausführungsbeispiel einer Vorrichtung zum Aufbringen eines pulverförmigen Beschichtungsmaterials auf eine Oberfläche eines Substrates,
- **Figur 1 B**: ein zweites Ausführungsbeispiel einer Vorrichtung zum Aufbringen eines pulverförmigen Beschichtungsmaterials auf eine Oberfläche eines Substrates,
- **Figur 2**: eine Vorrichtung entsprechend Figur 1 A mit einem als Hohlnadel ausgeführten Zuführorgan,
- **Figuren 3 A** - **E**: eine schematische Darstellung zur Veranschaulichung eins Verfahrens zum Aufbringen eines pulverförmigen Beschichtungsmaterials auf eine teilweise mit einer Deckschicht versehene Oberfläche eines Substrates,
- **Figursn 4 A - C**: eine schematische Darstellung zur Veranschaulichung eines Verfahrens zum Aufbringen eines pulverförmigen Beschichtungsmaterials auf eine Oberfläche mit unterschiedlichen Materialeigenschaften,
- **Figuren 5 A - C**: eine schematische Darstellung zur Veranschaulichung eines Verfahrens zur Herstellung eines dreidimensionalen Gegenstandes,
- **Figur 6**: eine schematische Darstellung zur Veranschaulichung eines Verfahrens zun strukturierten Aufbringen von Beschichtungsmaterialien auf die Oberfläche eines Substrates,
- **Figur 7**: eine bevorzugte Vorrichtung zum Aufbringen eines pulverförmigen Beschichtungsmaterials auf mehrere Substrate sowie
- **Figur 8**: eine Darstellung zur Veranschaulichung einer Hinterschneidungen aufweisenden Oberfläche eines Substrates.

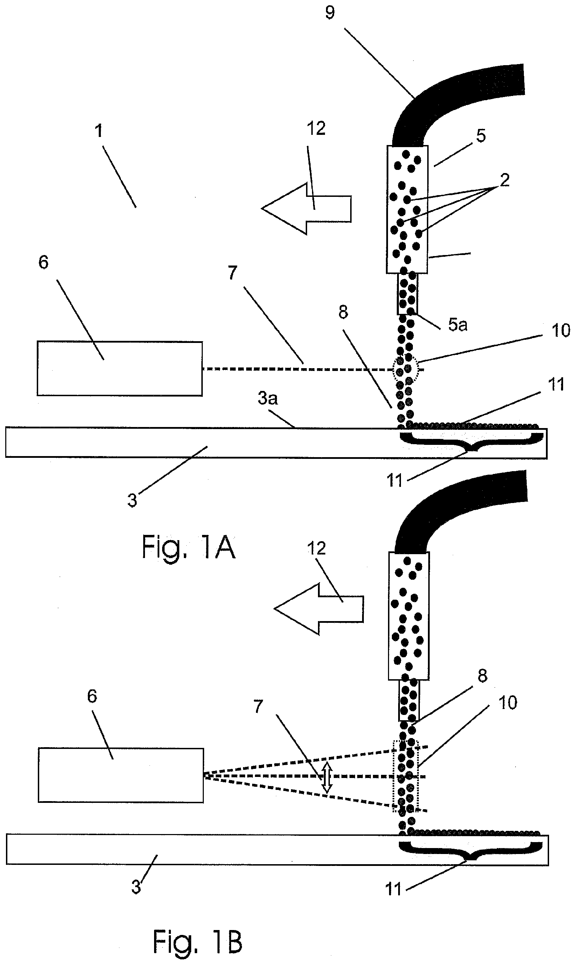

Die in Figur 1a schematisch dargestellte Vorrichtung (1) zum Aufbringen eines pulverförmigen Beschichtungsmaterials (2) auf eine Oberfläche (3a) eines Substrates (3) besteht im Wesentlichen aus einem lediglich teilweise dargestellten Pulverförderer (4), einem als Pulverdüse (5b) ausgeführten Zuführorgans (5) sowie einem Laser (6) zur Erzeugung eines Laserstrahls (7) parallel zur Oberfläche (3a) des Substrates (3) .

Der Pulverförderer (4) umfasst eine nicht dargestellte Pulverpumpe, die das pulverförmige Beschichtungsmaterial (2) aus einem Behälter in einen Trägergasstrom einbringt. Der Gasgemischstrom (8) wird über eine Zuführleitung (9) der Pulverdüse (5b) zugeführt. Der Auslass (5a) der Pulverdüse (5b) ist auf die Oberfläche (3a) des Substrates (3) ausgerichtet und weist einen vertikalen Abstand von etwa 50mm auf. Die Pulverdüse (5b) ist mit Hilfe eines nicht dargestellten Handhabungssystems in und entgegen der Richtung des Pfeils (12) parallel zur Oberfläche (3a) des Substrates bewegbar. Der Laser (6) ist vorzugsweise mit der Pulverdüse (5b) mechanisch gekoppelt und bewegt sich daher ebenfalls in Richtung des Pfeils (12) gegenüber dem im Ausführungsbeispiel nach Figur 1 ortsfest gehaltenen Substrat (3). Der Einkopplungsbereich (10), in dem der Laserstrahl (7) in den Gasgemischstrom (8) eingekoppelt wird, befindet sich unmittelbar oberhalb der Oberfläche (3a) des Substrates (3).

Durch die parallele Strahlführung des Laserstrahls (7) ist gewährleistet, dass der Laserstrahl (7) den Auftreffbereich (11) des Gasgemischstroms (8) auf der Oberfläche (3a) nicht trifft. Infolgedessen wird die Energie des Laserstrahls (7) im Einkopplungsbereich (1C) ausschließlich auf das pulverförmige Beschichtungsmaterial (2) in dem Gasgemischstrom (8) übertragen. Das bereits im Gasgemischstrom (8) durch die Einwirkung des Laserstrahls (7) zumindest teilweise geschmolzene pulverförmige Beschichtungsmaterial (2) wird unter Druck auf die Oberfläche (3a) aufgebracht.

Die Vorrichtung nach Figur 1 B) unterscheidet sich von der Vorrichtung nach Figur 1 A) im Wesentlich dadurch, dass der Laser (6) eine nicht dargestellte Laseroptik aufweist, die den Laserstrahl in Richtung des Einkopplungsbereichs (10) in den Gasgemischstrom (8) aufweitet. Hierdurch erstreckt sich der Einkopplungsbereich (10) über eine größere Länge des Gasgemischstroms (8) zwischen dem Auslass (5a) der Pulverdüse (5b) und der Oberfläche (3a). Durch die Aufweitung lässt sich bei entsprechender Anhebung der Laserleistung des defokussierten Laserstrahls (7) eine höhere Energie in das pulverförmige Beschichtungsmaterial (2) einkoppeln, um beispielsweise höher schmelzende metallische Beschichtungsmaterialien abscheiden zu können.

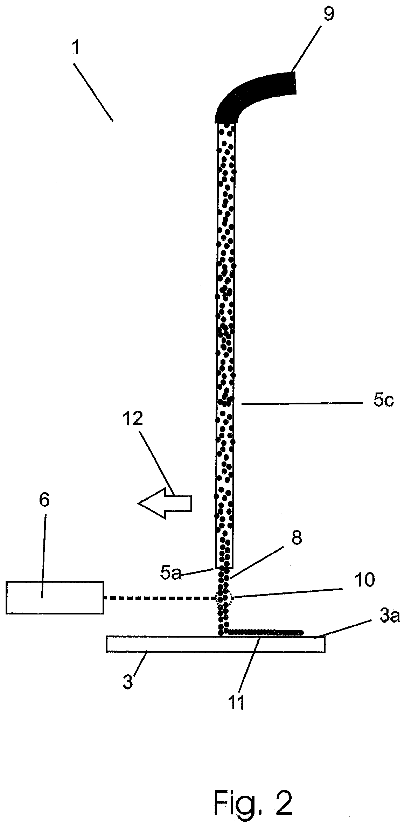

Die Vorrichtung (1) nach Figur 2 unterscheidet sich von der Vorrichtung nach Figur 1 A) lediglich hinsichtlich der Ausgestaltung des Zuführorgans (5). Zur Vermeidung von Wiederholungen wird daher vollumfänglich auf die Ausführungen zur Figur 1 A) verwiesen. Das Zuführorgan (5) ist als Hohlnadel (5c) ausgestaltet, die einen im Verhältnis zur Länge geringen Innendurchmessers von weniger als 10mm aufweist. Durch die Ausbildung des Zuführorgans (5) als Hohlnadel (5c) stellt sich eine quasi-laminare Strömung des Gasgemischstroms (8) zwischen dem Auslass (5a) und der Oberfläche (3a) des Substrates (3) ein.

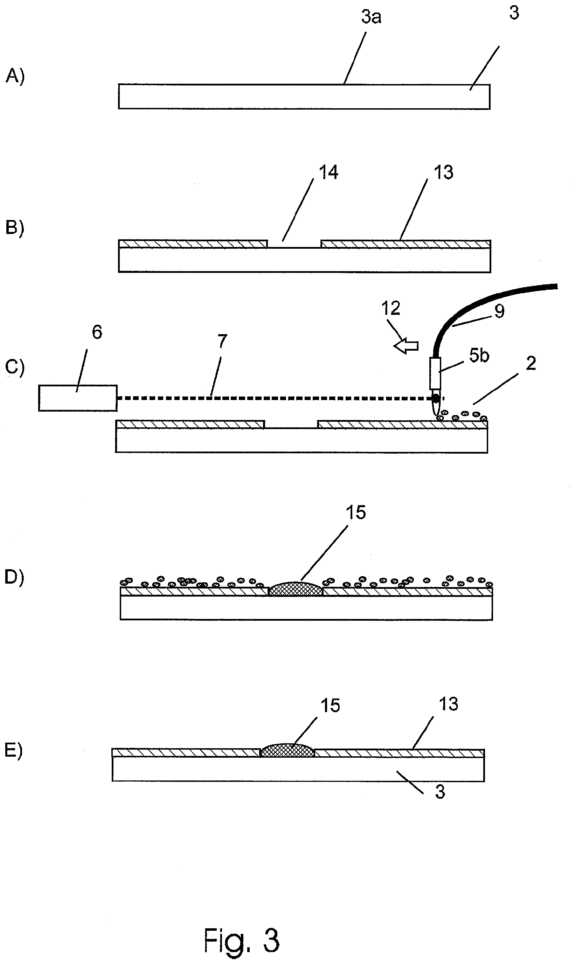

Anhand von Figur 3 wird das Aufbringen des pulverförmigen Beschichtungsmaterials (2) auf die Oberfläche (3a) eines teilweise mit einer Deckschicht (13) versehenen Substrates (3) näher erläutert: Die Oberfläche (3a) des Substrates (3) ist randseitig jeweils mit einer Deckschicht (13) versehen (vergleiche Figur 3b). Zwischen den randseitigen Abschnitten mit der Deckschicht (13) liegt die Oberfläche (3a) des Substrates (3a) in einem mittleren Bereich (14) frei. Die Deckschicht (13) weist haftabweisende Eigenschaften gegenüber dem pulverförmigen Beschichtungsmaterial (2) auf. Wird nun die Pulverdüse (5b) in Richtung des Pfeils (12) parallel zu der teilweise mit der Deckschicht (13) versehenen Oberfläche (3a) des Substrates (3) bewegt, wie dies in Figur 3 C) angedeutet ist, haftet das pulverförmige Beschichtungsmaterial (2) aufgrund der haftabweisenden Eigenschaften nicht auf der Deckschicht (13). Wie aus Figur 3 D) erkennbar, bildet das pulverförmige Beschichtungsmaterial (2) in dem mittleren Bereich (14) indes eine haftfeste Schicht (15) auf der Oberfläche (3a) des Substrates (3). Nach Beendigung des Aufbringens des Beschichtungsmaterials (2) wird die Oberfläche gereinigt. Figur 3 E) zeigt schließlich das gereinigte, lediglich im mittleren Bereich (14) selektiv beschichtete Substrat (3).

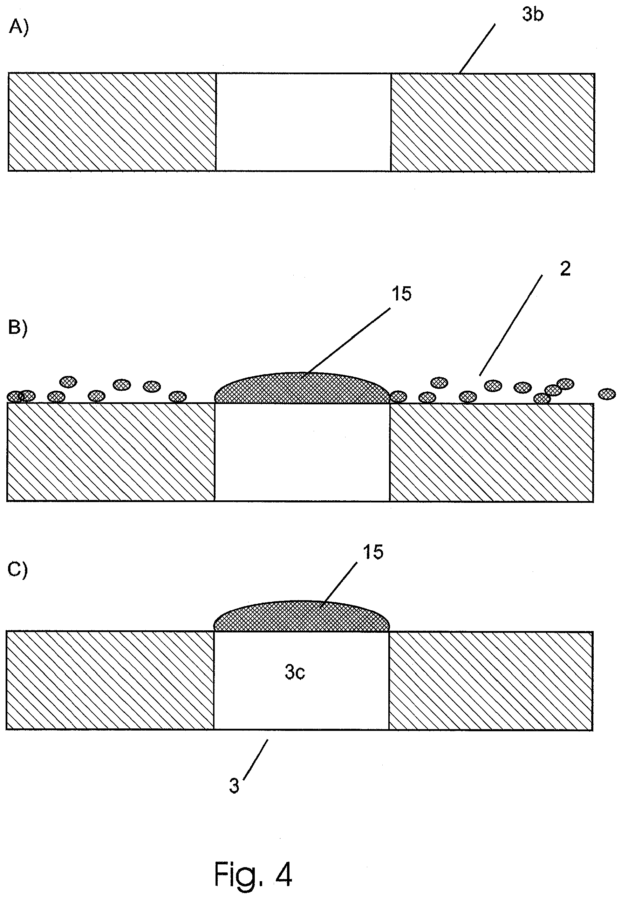

Figur 4 zeigt ein inhomogenes Substrat (3) mit Abschnitten (3b), die aus einem für das pulverförmige Beschichtungsmaterial (2) haftabweisendem Material bestehen und einem dazwischen angeordneten Abschnitt (3c), der aus einem gegenüber dem pulverförmigen Beschichtungsmaterials (2) haftvermittelnden Material besteht. Infolge der haftvermittelnden beziehungsweise haftabweisenden Eigenschaften der Abschnitte (3c, 3b), wird auf der Oberfläche (3a) des Substrates (3) in den Abschnitten (3b) keine haftfeste Verbindung zwischen dem Beschichtungsmaterial (2) und der Oberfläche erzeugt. Auf dem mittleren Abschnitt (3c) bildet sich indes eine haftfeste Schicht (15) aus dem Beschichtungsmaterial (2) aus. Nach dem Beenden des Aufbringens des Beschichtungsmaterials (2) wird die Oberfläche der Abschnitte (3b) von dem aufgebrachten Beschichtungsmaterial (2) befreit. Figur 4 C) zeigt schließlich das gereinigte, lediglich im Abschnitt (3c) selektiv beschichtete Substrat (3).

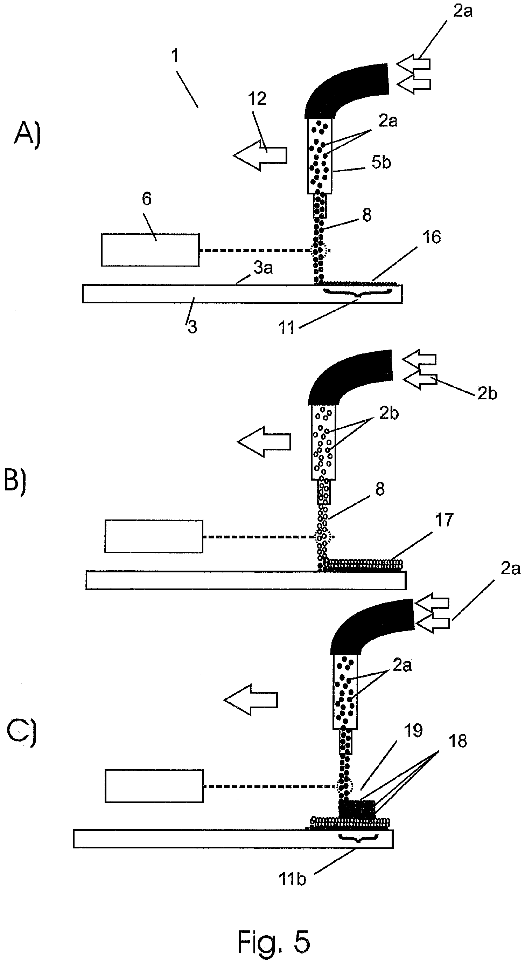

Figur 5 veranschaulicht schematisch ein Verfahren zum Aufbringen unterschiedlicher Beschichtungsmaterialien (2a, 2b) die nacheinander in mehreren Lagen übereinander abgeschieden werden. Die Vorrichtung (1) zum Aufbringen des Beschichtungsmaterials entspricht weitgehend der Vorrichtung nach Figur 1 A). Der nicht dargestellte Pulverförderer (4) weist jedoch zwei Pulverbehälter auf, aus denen die Pulverpumpe abwechselnd das erste oder zweite Beschichtungsmaterial (2a, 2b) in den Trägergasstrom einbringt. Der Gasgemischstrom (8) weist daher wahlweise das erste oder zweite Beschichtungsmaterial (2a, 2b) auf.

Figur 5 A) zeigt, wie die Oberfläche (3a) des Substrates (3) zunächst in dem Auftreffbereich (11) durch Relativbewegung der Pulverdüse (5b) in Richtung des Pfeils (12) mit dem ersten Beschichtungsmaterial (2a) beschichtet wird. Anschließend wird, wie in Figur 5 B) dargestellt auf die Oberfläche der ersten Lage (16) aus dem ersten Beschichtungsmaterial (2a) eine zweite Lage (17) mit dem zweiten Beschichtungsmaterial (2b) aufgebracht. Schließlich werden, wie in Figur 5 C) dargestellt auf der Oberfläche der zweiten Lage (17) durch mehrfache Hin- und Herbewegung der Pulverdüse (5b) in einem kleineren Auftreffbereich (11b) vier dritte Lagen (18) mit dem ersten Beschichtungsmaterial (2a) aufgebracht.

Die während des Aufbringens durch den Laserstrahl (7) aufgeschmolzenen ersten und zweiten Beschichtungsmaterialien (2a, 2b) gehen untereinander einen haftfesten Verbund ein, sodass sich der in Figur 5 C) erkennbare Gegenstand (19) mit Hilfe des erfindungsgemäßen Verfahrens erzeugen lässt.

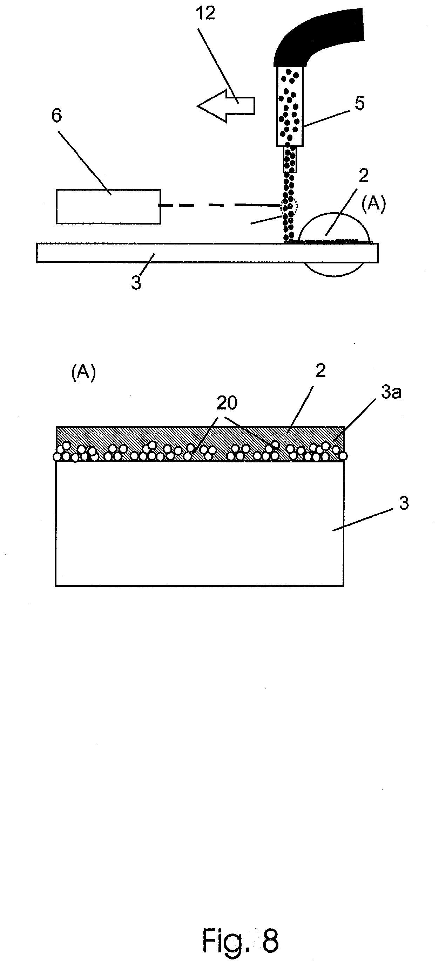

Abhängig von der Oberflächenbeschaffenheit des Substrats (3) verbindet sich die erste Lage (16) mit der Oberfläche (3a) oder geht mit dieser keinen haftfesten Verbund ein. Im letztgenannten Fall dient die Oberfläche (3a) lediglich als temporärer Träger für die Herstellung des Gegenstandes (19). Sofern jedoch eine dauerhafte Anhaftung des Beschichtungsmaterials (2) an der Oberfläche gewünscht ist, empfiehlt es sich die Oberfläche entsprechend Figur 8 aufzurauen, wodurch sich, wie aus der Vergrößerung A erkennbar, Hinterschneidungen (20) bilden, in denen sich das Beschichtungsmaterial (2) verzahnen kann.

Üblicherweise weisen Gegenstände die mittels Gieß-, Extrusions oder Pressverfahren erzeugt werden glatte Oberflächen mit einer geringen Rauhigkeit und keinen Hinterschneidungen auf. Sofern eine Anhaftung des Beschichtungsmaterials an der Oberfläche des Gegenstandes gewünscht ist, stellt die mechanische Verklammerung des zumindest teilweise geschmolzenen Beschichtungsmaterials in den Hinterschneidungen der Oberfläche einen wesentlichen Haftmechanismus dar. Es ist daher sinnvoll die Oberfläche derart zu gestalten, das Hinterschneidungen in einer Größenordnung von 0,1 µm - 100 µm wiederholt und über die Oberfläche verteilt vorliegen. Hierzu kann z.B. mittels Laser eine Aufrauhung der Oberfläche und gleichzeitige Bildung von Mikro-Hinterschnitten in den Bereichen der Oberfläche mit haftvermittelnden Eigenschaften erzeugt werden.

Alternativ kann z.B. in einem ersten Verfahrensschritt eine haftvermittelnde, keramische Beschichtung mit Hinterschneidungen auf der glatten Oberfläche des Gegenstandes abgeschieden werden. Hierzu wird pulverförmiges keramisches Beschichtungsmaterial angeschmolzen und auf der Oberfläche mittels eines Plasmabeschichtungsverfahrens abgeschieden. Durch die Wahl von geeigneten Pulverpartikelgrößen (1-50µm) und Beschichtungsparametern können gezielt Hinterschneidungen auf der Oberfläche erzeugt werden, indem die Partikel nicht vollständig aufgeschmolzen, sondern im Kern noch erhalten bleiben. Die Aneinderhäufung von teilweise runden, spratzigen oder undefinierte Pulverpartikeln auf der Oberfläche führt zu einem offenporigem Gebilde mit zahlreichen Hinterschneidungen. Derartige keramische, haftvermittelnde Schichten werden vorzugsweise in Dicken von 1-500 µm auf der Oberfläche aufgebracht. Das nachfolgend auf die keramische, haftvermittelnde Schicht mit dem erfindungsgemäßen Verfahren aufgebrachte Beschichtungsmaterial verzahnt sich mechanisch in den Hinterschneidungen.

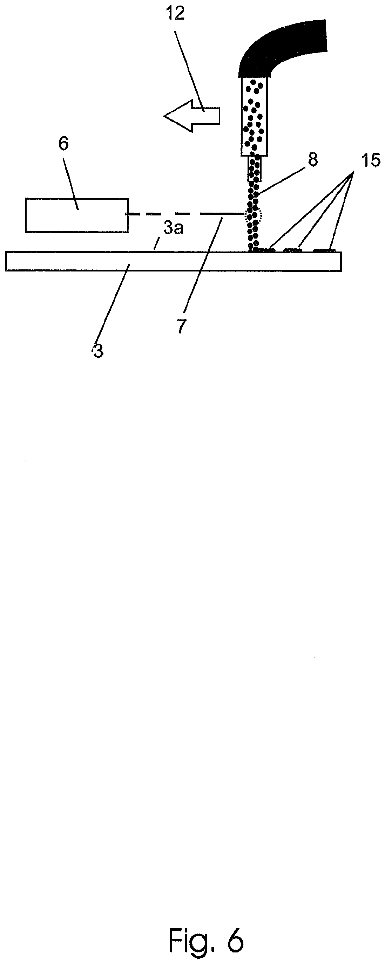

Anhand von Figur 6 wird das erfindungsgemäße abschnittsweise strukturierte Aufbringen des pulverförmigen Beschichtungsmaterials (2) mit einer Vorrichtung nach Figur 1 A) erläutert: Während des kontinuierlichen Zuführens des Gasgemischstroms (8) wird zeitweise der Laserstrahl (7) unterbrochen, was beispielsweise durch das Ein- und Ausschalten der Laserleistung erfolgt. Während der Laser (6) eingeschaltet ist und der Laserstrahl (7) in den Gasgemischstrom (8) eingekoppelt wird, wird das Beschichtungsmaterial (2) haftfest auf der Oberfläche (3a) des Substrates (3) abgeschieden. In den Unterbrechungsphasen des Lasers (6) wird zwar Beschichtungsmaterial (2) auf die Oberfläche (3a) aufgebracht. Da jedoch keine Laserenergie in das Beschichtungsmaterial (2) eingekoppelt wird, wird dieses nicht ausgeschmolzen und verbindet sich daher nicht haftfest mit der Oberfläche (3a). Durch periodisches Ein- und Ausschalten ergibt sich nach dem Entfernen des nicht haftfesten Beschichtungsmaterials (2) die aus Figur 6 erkennbare Abfolge haftfester Schichten (15).

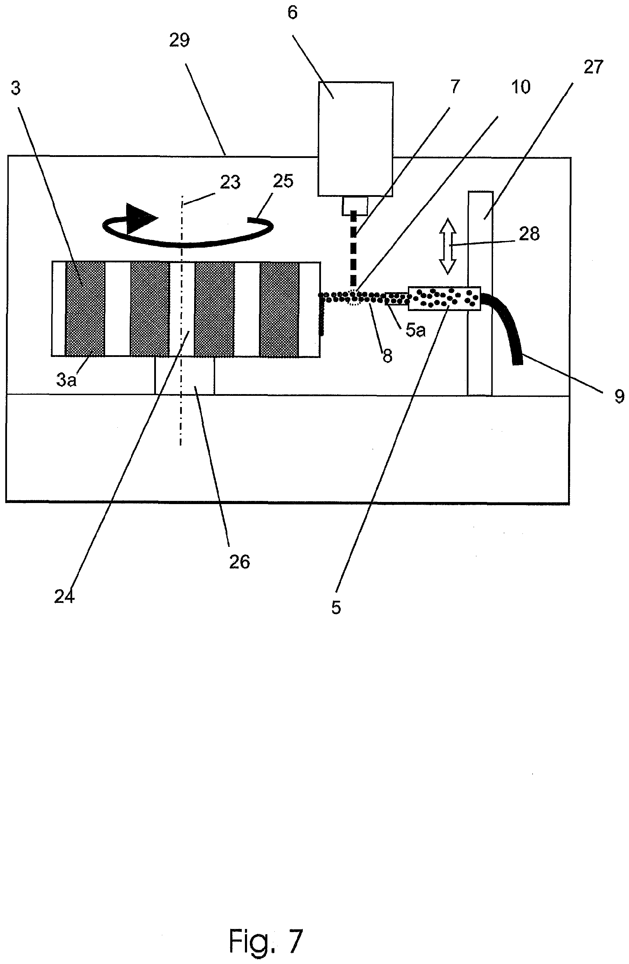

Nachfolgend wird anhand von Figur 7 eine bevorzugte Vorrichtung (1) zur Durchführung des erfindungsgemäßen Verfahrens beschrieben. Die Vorrichtung (1) weist einen um eine Drehachse (23) drehbaren Drehtisch (24) auf. Um den Drehtisch (24) um die Drehachse (23) in Richtung und entgegen der Richtung des Pfeils (25) in Drehung zu versetzen, weist der Drehtisch (24) einen Antrieb (26) auf. Am äußeren Umfang des Drehtisches (24) sind Substrate (3) mit nach außen weisender Oberfläche (3a) lösbar befestigt.

Die Vorrichtung (1) weist ferner ein Linearsystem (27), beispielsweise einen angetriebenen Linearschlitten auf, der das Zuführorgan (5) in Richtung einer linearen Verschiebeachse (28) bewegen kann. Der Auslass (5a) des Zuführorgans (5) wird nacheinander auf die Oberfläche (3a) jeweils eines Substrates (3) gerichtet, damit der Gasgemischstrom (8) der Substratoberfläche (3a) zugeführt werden kann, Das Zuführorgan (5) ist derart an dem Linearsystem (27) angeordnet, dass der Gasgemischstrom (8) senkrecht auf die Oberfläche (3a) jedes Substrates (3) auftrifft. Die Verschiebeachse (28) verläuft parallel zu der Drehachse (23) des Drehtischs (24). Durch Verschieben des Zuführorgans (5) in und/oder entgegen der Verschiebeachse (28) kann daher das Beschichtungsmaterial (2) bahnförmig auf dem jeweils mit Hilfe des Drehtisches gegenüber dem Auslass (5a) des Zuführorgans (5) positionierten Substrat (3) aufgebracht werden. Sofern die Beschichtung nicht mit einer Spur auf dem Substrat (3) aufgebracht werden kann, lassen sich mehrere vertikale Spuren nebeneinander dadurch aufbringen, dass der Drehtisches (24) nach dem Aufbringen jeder Spur geringfügig gedreht wird.

Der Laser (6) kann, wie in Figur 7 dargestellt, ortsfest oder an einer Handhabungsvorrichtung angeordnet sein. Die Laseroptik ist derart ausgerichtet, dass der Laserstrahl (7) in dem Einkopplungsbereich (10) senkrecht auf den Gasgemischstrom (8) trifft.

Die Vorrichtung (22) ist schließlich von einer Einhausung (29) zur Ausbildung eines Arbeitsraumes umgeben. Der Antrieb sowohl des Drehtisches (24) als auch des Linearsystems (27) sowie der Laser (6) sind programmgesteuert, um eine vollautomatische Beschichtung der Substrate (3) zu gewährleisten.

Nachfolgend werden beispielhaft einige Anwendungsfälle des erfindungsgemäßen Verfahrens genannt;
1. In der Elektronikindustrie kann das Verfahren zum Abscheiden von strukturierten Leiterbahnen auf dreidimensionalen Körpern, insbesondere aus Kunststoff und Keramik verwendet werden. Darüber hinaus kommt das Verfahren zum Abscheiden von strukturierten Leiterbahnen auf ebenen Leiterbahnenplatinen zum Einsatz.
2. In der Halbleiterindustrie kann das Verfahren zum Abscheiden poröser Metellschichten auf Wafern, beispielsweise zur Herstellung von IGBT-Modulen verwendet werden. Darüber hinaus lassen sich mit dem erfindungsgemäßen Verfahren Kontakte zwischen Halbleitern und Trägerkörpern als Ersatz von Bondverbindungen herstellen.
3. Insbesondere in der Medizintechnik kann das Verfahren auch in evakuierten Arbeitsräumen durchgeführt werden, um unter Ausschluss der Atmosphäre beispielsweise medizinisch wirksame Beschichtungen für Implantate herzustellen.
4. Im Bereich der Photovoltaik lassen sich mit dem erfindungsgemäßen Verfahren elektrisch leitfähige Kontaktstrukturen und/oder Halbleitermaterialien auf den Solarzellen abscheiden.
5. Im Bereich der Displayherstellung lassen sich mit dem erfindungsgemäßen Verfahren beispielsweise leitfähige Strukturen auf der Oberfläche von Gläsern zur Herstellung von Displays abscheiden.
6. In industriellen Rolle zu Rolle Beschichtungsprozessen lassen sich beispielsweise Folienbahnen und Bögen mit porösen Metallschichten versehen, die mittels eines sich vorzugsweise aufweitenden Gasgemischstroms aufgebracht werden.

| Nr. | **Bezeichnung** |
|---|---|
| 1. | Vorrichtung |
| 2. | Beschichtungsmaterial |
| 2a. | Erstes Beschichtungsmaterial |
| 2b. | Zweites Beschichtungsmaterial |
| 3. | Substrat |
| 3a. | Oberfläche |
| 3b. | Substratabschnitt |
| 3c. | Substratabschnitt |
| 4. | Pulverförderer |
| 5. | Zuführorgan |
| 5a. | Auslass |
| 5b. | Pulverdüse |
| 5c. | Hohlnadel |
| 6. | Laser |
| 7. | Laserstrahl |
| 8. | Gasgemischstrom |
| 9. | Zuführleitung |
| 10. | Einkopplungsbereich |
| 11/11b. | Auftreffbereich |
| 12. | Pfeil |
| 13. | Deckschicht |
| 14. | Mittlerer Bereich |
| 15. | Haftfeste Schicht |
| 16. | Erste Lage |
| 17. | Zweite Lage |
| 18. | Dritte Lage |
| 19. | Gegenstand |
| 20. | Hinterschneidungen |
| 21. | - |
| 22. | Vorrichtung |
| 23 | Drehachse |
| 24. | Drehtisch |
| 25. | Pfeil |
| 26. | Antrieb |
| 27. | Linearsystem |
| 28. | Verschiebeachse |
| 29 | Einhausung |

## Patentansprüche

1. Verfahren zum Aufbringen eines Beschichtungsmaterials (2) auf eine Oberfläche (3a) umfassend die Schritte:
- Bereitstellen eines Gasgemischstroms (8) umfassend ein Trägergas und ein festes, pulverförmiges Beschichtungsmaterial (2),
- Zuführen des Gasgemischstroms (8) zu der Oberfläche (3a), wobei der Gasgemischstrom (8) auf die Oberfläche (3a) auftrifft und das dort aufgebrachte Beschichtungsmaterial (3a) einem Auftreffbereich (11) auf der Oberfläche (3a) ausbildet und die Oberfläche (3a) und der Gasgemischstrom (8) während des Aufbringens des Beschichtungsmaterials (2) relativ zueinander bewegt werden,
- Einkoppeln mindestens eines Laserstrahls (7) in den Gasgemischstroms (8),
- wobei die eingekoppelte Energie des mindestens einen Laserstrahls (7) derart bestimmt wird, dass das Beschichtungsmaterial (2) zumindest teilweise schmilzt und
- wobei jeder Laserstrahl (7) derart auf den Gasgemischstrom (8) ausgerichtet wird, dass der Laserstrahl (7) den Auftreffbereich (11) auf der Oberfläche nicht trifft,
**dadurch gekennzeichnet, dass**
- während des Zuführens des Gasgemischstroms (8) das Einkoppeln des mindestens einen Laserstrahls (8) zeitweilig unterbrochen wird.

2. Verfahren nach Anspruch 1, **dadurch gekennzeichnet, dass** das Beschichtungsmaterial ausschließlich durch die eingekoppelte Energie des mindestens einen Laserstrahls (7) teilweise schmilzt.

3. Verfahren nach Anspruch 2, **dadurch gekennzeichnet, dass**, dass zumindest die Oberfläche der Pulverpartikel schmilzt.

4. Verfahren nach einem der Ansprüche 1 bis 3, **dadurch gekennzeichnet, dass** der mindestens eine Laserstrahl (7) kontinuierlich mittels eines Dauerstrichlasers oder diskontinuierlich mittels eines Pulslasers eingekoppelt wird.

5. Verfahren nach Anspruch 4, **dadurch gekennzeichnete dass** der mindestens eine Laserstrahl (7) mittels einer Laseroptik fokussiert oder defokussiert eingekoppelt wird.

6. Verfahren nach einem der Ansprüche 1 bis 5, **dadurch gekennzeichnet, dass** während des Einkoppelns des mindestens eines Laserstrahls (7) in den Gasgemischstroms (8) die Ausrichtung jedes Laserstrahl (7) unverändert beibehalten wird.

7. Verfahren nach einem der Ansprüche 1 bis 5, **dadurch gekennzeichnet, dass** während des Einkoppelns des mindestens eines Laserstrahls (7) in den Gasgemischstroms (8) die Ausrichtung jedes Laserstrahls (7) verändert wird.

8. Verfahren nach einem der Ansprüche 1 bis 7, **dadurch gekennzeichnet, dass** der Gasgemischstrom (8) mit einem Volumenstrom des Trägergases im Bereich von 1 - 50 1/min, vorzugsweise 1 - 20 l/min, bereitgestellt wird.

9. Verfahren nach einem der Ansprüche 1 bis 8, **dadurch gekennzeichnet, dass** der Gasgemischstrom (8) mit einem Massestrom des Beschichtungsmaterials (2) im Bereich von 0,1 g/min - 100g/min, vorzugsweise 2 g/min - 20 g/min, bereitgestellt wird.

10. Verfahren nach einem der Ansprüche 1 bis 9, **dadurch gekennzeichnet, dass** das Trägergas ein Insrtgas, Stickstoff oder Umgebungsluft ist.

11. Verfahren nach einem der Ansprüche 1 bis 10, **dadurch gekennzeichnet, dass** das Beschichtungsmaterial (2) eine Korngrößenverteilung von 100 nm bis 120 µm aufweist.

12. Verfahren nach einem der Ansprüche 1 bis 11, **dadurch gekennzeichnet, dass** das Zuführen des Gasgemischstroms (8) mit Hilfe eines Zuführorgans (5) mit einem Auslass (5a) für den Gasgemischstrom (8) erfolgt, wobei der Auslass in einem vertikalen Abstand im Bereich von 1 mm - 100 mm zu dem Auftreffbereich gehalten wird.

13. Verfahren nach einem der Ansprüche 1 bis 12, **dadurch gekennzeichnet, dass** das Zuführen des Gasgemischstroms (8) mit Hilfe einer Hohlnadel (5c) erfolgt, die einen Innendurchmesser im Bereich von 0,1 - 10 mm aufweist.

14. Verfahren nach einem der Ansprüche 1 bis 12, **dadurch gekennzeichnet, dass** das Zuführen des Gasgemischstroms (8) mit Hilfe eines Diffusors erfolgt, der den Strömungsquerschnitt des Gasgemischstroms aufweitet.

15. Verfahren nach einem der Ansprüche 1 bis 14, **dadurch gekennzeichnet, dass** die Oberfläche (3a) mit dem Auftreffbereich (11) Bestandteil eines Substrats (3) ist.

16. Verfahren nach einem der Ansprüche 1 bis 15, **dadurch gekennzeichnet, dass** mehrere Lagen(16, 17, 18) des Beschichtungsmaterials (2, 2a, 2b) übereinander abgeschieden werden.

17. Verfahren nach einem der Ansprüche 1 bis 16, **dadurch gekennzeichnet, dass** die Oberfläche (3a) mit den Auftreffbereich (11) Hinterschneidungen (2C) aufweist.

18. Verfahren nach einem der Ansprüche 1 bis 17, **dadurch gekennzeichnet, dass** vor dem Zuführen des Gasgemischstroms (8) die Oberfläche (3a) teilweise mit einer Deckschicht (13) versehen wird, die haftabweisende Eigenschaften gegenüber dem mit dem Gasgemischstrom (8) anschließend zugeführten Beschichtungsmaterial (2) aufweist.

19. Verfahren nach einem der Ansprüche 1 bis 17, **dadurch gekennzeichnet, dass** die Oberfläche (3a) oder ein die Oberfläche (3a) aufweisender Gegenstand zumindest abschnittsweise aus einem Opfermaterial besteht, wobei das Opfermaterial haftabweisende Eigenschaften gegenüber dem mit dem Gasgemischstrom (8) zugeführten Beschichtungsmaterial (2) aufweist.

20. Verfahren nach Anspruch 19, **dadurch gekennzeichnet, dass** das Opfermaterial mindestens eine Acrylgruppe (CH2=CH-COR) umfasst, wobei der Anteil der Acrylgruppe vorzugsweise mindestens ein 1 Gewichtsprozent des Opfermaterials beträgt.

21. Vorrichtung (1) zum Aufbringen eines Beschichtungsmaterials (2) auf eine Oberfläche (3a) zur Durchführung des Verfahrens nach einem der Ansprüche 1 bis 20 umfassend
- einen Pulverförderer (4) eingerichtet zum Bereitstellen eines Gasgemischstroms (8) umfassend ein Trägergas und ein Beschichtungsmaterial (2),
- ein Zuführorgan (5) zum Zuführen des Gasgemischstroms zu der Oberfläche (3a), wobei das Zuführorgan (5) derart eingerichtet ist, dass der Gasgemischstrom (8) auf die Oberfläche (3a) auftrifft und das dort aufgebrachte Beschichtungsmaterial einen Auftreffbereich (11) auf der Oberfläche ausbildet,
- einen Laser (6) zur Erzeugung eines Laserstrahls (7) eingerichtet zum Einkoppeln des Laserstrahls (7) in den Gasgemischstroms (8),
- wobei jeder Laserstrahl (7) derart zu dem Gasgemischstrom (8) ausgerichtet ist, dass der Laserstrahl (7) den Auftreffbereich (11) auf der Oberfläche nicht trifft,
- ein zur Erzeugung einer Relativbewegung zwischen dem Zuführorgan (5) und der zu beschichtenden Oberfläche (3a) eingerichtetes Handhabungssystem,
- Mittel zur zeitweiligen Unterbrechung des Einkoppelns des Laserstrahls (7) in den Gasgemischstroms (8), nämlich
- durch Ausblenden des Laserstrahls (7) mit einer Blende oder
- durch Ablenkung des Laserstrahls (7) mit einer Laseroptik derart, dass der Laserstrahl (7) zeitweilig nicht auf den Gasgemischstrom (8) ausgerichtet ist.

22. Vorrichtung nach Anspruch 21, **dadurch gekennzeichnet, dass**
- das Handhabungssystem einen um eine Drehachse (23) drehbaren Drehtisch (24) aufweist, der zur Aufnahme mindestens eines die zu beschichtende Oberfläche (3a) aufweisenden Objektes eingerichtet ist,
- das Handhabungssystem ein Linearsystem (27) aufweist, das zur Erzeugung einer linearen Bewegung des Zuführorgans (5) in Richtung einer Verschiebeachse (28) eingerichtet ist,
- wobei die Verschiebeachse (28) parallel zu der der Drehachse (23) verläuft

23. Vorrichtung nach Anspruch 22, **dadurch gekennzeichnet, dass** der Laser (6) eine zur Ausrichtung des Laserstrahls (7) eingerichtete Laseroptik aufweist und /oder der Laser (6) an einer zur Ausrichtung des Laserstrahls (7) eingerichteten Handhabungsvorrichtung angeordnet ist.

## Claims

1. A process for applying a coating material (2) to a surface (3a) comprising the steps:
- providing a gas mixture stream (8) comprising a carrier gas and a solid, powdered coating material (2);
- feeding the gas mixture stream (8) to the surface (3a), wherein the gas mixture stream (8) impinges on the surface (3a) and the coating material (3a) applied to the surface forms an impingement area (11) on the surface (3a), and the surface (3a) and the gas mixture stream (8) are moved relative to one another during the application of the coating material (2),
- coupling at least one laser beam (7) into the gas mixture stream (8),
- wherein the coupled-in energy of the at least one laser beam (7) is determined in such a manner that the coating material (2) is at least partially melted and
- wherein each laser beam (7) is aligned in such a manner onto the gas mixture stream (8) such that the laser beam (7) does not impinge on the impingement area (11) on the surface, **characterized in that**
- during the feeding of the gas mixture stream (8), the coupling-in of the at least one laser beam (8) is temporarily interrupted.

2. The process according to claim 1, **characterized in that** the coating material is only partially melted by the coupled-in energy of the at least one laser beam (7) .

3. The process according to claim 2, **characterized in that** at least the surface of the powder particles melts.

4. The process according to one of claims 1 to 3, **characterized in that** the at least one laser beam (7) is coupled in continuously by a continuous wave laser or discontinuously by a pulsed laser.

5. The process according to claim 4, **characterized in that** the at least one laser beam (7) is coupled in as focused or defocused by a laser optical unit.

6. The process according to one of claims 1 to 5, **characterized in that**, during the coupling of the at least one laser beam (7) into the gas mixture stream (8), the alignment of each laser beam (7) is kept unchanged.

7. The process according to one of claims 1 to 5, **characterized in that**, during the coupling of the at least one laser beam (7) into the gas mixture stream (8), the alignment of each laser beam (7) is changed.

8. The process according to one of claims 1 to 7, **characterized in that** the gas mixture stream (8) is provided with a volumetric flow of the carrier gas in the range from 1-50 l/min, preferably 1-20 l/min.

9. The process according to one of claims 1 to 8, **characterized in that** the gas mixture stream (8) is provided with a mass flow of the coating material (2) in the range from 0.1 g/min-100 g/min, preferably 2 g/min-20 g/min.

10. The process according to one of claims 1 to 9, **characterized in that** the carrier gas is an inert gas, nitrogen or ambient air.

11. The process according to one of claims 1 to 10, **characterized in that** the coating material (2) has a grain size distribution of 100 nm to 120 µm.

12. The process according to one of claims 1 to 11, **characterized in that** the feeding of the gas mixture stream (8) is performed using a feeding element(5) with an outlet (5a) for the gas mixture stream (8), wherein the outlet is kept at a vertical distance from the impingement area in the range from 1 mm-100 mm.

13. The process according to one of claims 1 to 12, **characterized in that** the feeding of the gas mixture stream (8) is performed using a hollow needle (5c) which has an inside diameter in the range from 0.1-10 mm.

14. The process according to one of claims 1 to 12, **characterized in that** the feeding of the gas mixture stream (8) is performed using a diffuser, which widens the flow cross-section of the gas mixture stream.

15. The process according to one of claims 1 to 14, **characterized in that** the surface (3a) with the impingement area (11) is a component of a substrate (3) .

16. The process according to one of claims 1 to 15, **characterized in that** a plurality of layers (16, 17, 18) of the coating material (2, 2a, 2b) are deposited one on top of the other.

17. The process according to one of claims 1 to 16, **characterized in that** the surface (3a) with the impingement area (11) has undercuts (20).

18. The process according to one of claims 1 to 17, **characterized in that** before the feeding of the gas mixture stream (8), the surface (3a) is at least partially provided with a top layer (13) which has anti-adhesive properties with respect to the coating material (2) that is subsequently fed with the gas mixture stream (8).

19. The process according to one of claims 1 to 17, **characterized in that** the surface (3a) or an article having the surface (3a) consists of a sacrificial material at least in certain portions, wherein the sacrificial material has anti-adhesive properties with respect to the coating material (2) that is fed with the gas mixture stream (8).

20. The process according to claim 19, **characterized in that** the sacrificial material comprises at least one acrylic group (CH2=CH-COR), wherein the proportion of the acrylic group is preferably at least 1 percent by weight of the sacrificial material.

21. A device (1) for applying a coating material (2) to a surface (3a) for carrying out the process according to one of claims 1 to 20 comprising
- a powder conveyor (4)adapted to provide a gas mixture stream (8) comprising a carrier gas and a coating material (2),
- a feeding element (5) for feeding the gas mixture stream to the surface (3a), wherein the feeding element (5) is adapted in such a manner that the gas mixture stream (8) impinges on the surface (3a) and the coating material applied on the surface forms an impingement area (11) on the surface,
- a laser (6) for producing a laser beam (7), adapted to couple the laser beam (7) into the gas mixture stream (8),
- wherein each laser beam (7) is aligned with respect to the gas mixture stream (8) in such a manner that the laser beam (7) does not impinge on the impingement area (11) on the surface,
- a handling system adapted to produce a relative movement between the feeding element (5) and the surface (3a) to be coated,
- means for temporarily interrupting the coupling of the laser beam (7) into the gas mixture stream (8), namely
- by shutting off the laser beam (7) with a shutter or
- by deflecting the laser beam (7) with a laser optical unit in such a manner that the laser beam (7) is temporarily not directed onto the gas mixture stream (8).

22. The device according to claim 21, **characterized in that**
- the handling system comprises a turntable (24) which is rotatable about an axis of rotation (23) and is adapted to receive at least one object having the surface (3a) to be coated,
- the handling system has a linear system (27) which is adapted to produce a linear movement of the feeding element (5) in the direction of an axis of displacement (28),
- wherein the axis of displacement (28)runs parallel to the axis of rotation (23).

23. The device according to claim 22, **characterized in that** the laser (6) comprises a laser optical unit adapted for aligning the laser beam (7) and/or the laser (6) is arranged on a handling device adapted to align the laser beam (7).

## Revendications

1. Procédé, destiné à appliquer une matière de revêtement (2) sur une surface (3a), comprenant les étapes consistant à :
- mettre à disposition un flux de mélange gazeux (8) comprenant un gaz porteur et une matière de revêtement (2) solide pulvérulente,
- alimenter le flux de mélange gazeux (8) vers la surface (3a), le flux de mélange gazeux (8) étant incident sur la surface (3a) et la matière de revêtement (3a) qui y est appliquée formant une zone d'incidence (11) sur la surface (3a} et la surface (3a) ainsi que le flux de mélange gazeux (8) étant déplacés l'un par rapport à l'autre pendant l'application de la matière de revêtement (2),
- injecter au moins un faisceau laser (7) dans le flux de mélange gazeux (8),
- l'énergie injectée de l'au moins un faisceau laser (7) étant déterminée de telle sorte que la matière de revêtement (2) fonde au moins partiellement et
- chaque faisceau laser (7) étant orienté sur le flux de mélange gazeux (8) de telle sorte que le faisceau laser (7) ne touche pas la zone d'incidence (11) sur la surface,
**caractérisé en ce que**
- pendant l'alimentation du flux de mélange gazeux (8), on interrompt temporairement l'injection de l'au moins un faisceau laser (8).

2. Procédé selon la revendication 1, **caractérisé en ce que** la matière de revêtement fond partiellement, exclusivement sous l'effet de l'énergie injectée de l'au moins un faisceau laser (7).

3. Procédé selon la revendication 2, **caractérisé en ce qu'**au moins la surface de la particule pulvérulente fond.

4. Procédé selon l'une quelconque des revendications 1 à 3, **caractérisé en ce qu'**on injecte l'au moins un faisceau laser (7) en continu au moyen d'un laser continu ou de manière discontinue, au moyen d'un laser pulsé.

5. Procédé selon la revendication 4, **caractérisé en ce qu'**on injecte l'au moins un faisceau laser (7) en le focalisant ou en le défocalisant au moyen d'une optique à laser.

6. Procédé selon l'une quelconque des revendications 1 à 5, **caractérisé en ce que** pendant l'injection de l'au moins un faisceau laser (7) dans le flux de mélange gazeux (8), on maintient invariablement l'orientation de chaque faisceau laser (7).

7. Procédé selon l'une quelconque des revendications 1 à 5, **caractérisé en ce que** pendant l'injection de l'au moins un faisceau laser (7) dans le flux de mélange gazeux (8), on fait varier l'orientation de chaque faisceau laser {7).

8. Procédé selon l'une quelconque des revendications 1 à 7, **caractérisé en ce qu'**on met à disposition le flux de mélange gazeux (8) avec un débit volumétrique du gaz porteur de l'ordre de 1 à 50 litres/mn, de préférence de 1 à 20 litres/mn.

9. Procédé selon l'une quelconque des revendications 1 à 8, **caractérisé en ce qu'**on met à disposition le flux de mélange gazeux (8) avec un débit massique de la matière de revêtement (2) de l'ordre de 0,1 g/mn à 100g/mn, de préférence de 2 g/mn à20 g/mn.

10. Procédé selon l'une quelconque des revendications 1 à 9, **caractérisé en ce que** le gaz porteur est un gaz inerte, de l'azote ou de l'air ambiant.

11. Procédé selon l'une quelconque des revendications 1 à 10, **caractérisé en ce que** la matière de revêtement (2) présente une distribution granulométrique de 100 nm à 120 µm.

12. Procédé selon l'une quelconque des revendications 1 à 11, **caractérisé en ce que** l'alimentation du flux de mélange gazeux (8) a lieu à l'aide d'un organe d'alimentation (5) pourvu d'une sortie (5a) pour le flux de mélange gazeux (8), la sortie étant maintenue avec un écart vertical de l'ordre de 1 mm à 100 mm par rapport à la zone d'incidence.

13. Procédé selon l'une quelconque des revendications 1 à 12, **caractérisé en ce que** l'alimentation du flux de mélange gazeux (8) a lieu à l'aide d'une aiguille creuse (5c) qui présente un diamètre intérieur de l'ordre de 0,1 à 10 mm.

14. Procédé selon l'une quelconque des revendications 1 à 12, **caractérisé en ce que** l'alimentation du flux de mélange gazeux (8) a lieu à l'aide d'un diffuseur qui évase la section transversale d'écoulement du flux de mélange gazeux.

15. Procédé selon l'une quelconque des revendications 1 à 14, **caractérisé en ce que** la surface (3a) pourvue de la zone d'incidence (11) est une partie d'un substrat (3) .

16. Procédé selon l'une quelconque des revendications 1 à 15, **caractérisé en ce qu'**on dépose en superposition plusieurs couches (16, 17, 18) de la matière de revêtement (2, 2a, 2b).

17. Procédé selon l'une quelconque des revendications 1 à 16, **caractérisé en ce que** la surface (3a) pourvue de la zone d'incidence (11) comporte des contre-dépouilles (2C).

18. Procédé selon l'une quelconque des revendications 1 à 17, **caractérisé en ce qu'**avant l'alimentation du flux de mélange gazeux (8), on munit partiellement la surface (3a) d'une couche de recouvrement (13), qui fait preuve de propriétés anti-adhérentes par rapport à la matière de revêtement (2) alimentée par la suite avec le flux de mélange gazeux (8).

19. Procédé selon l'une quelconque des revendications 1 à 17, **caractérisé en ce que** la surface (3a) ou un objet présentant la surface (3a) est constitué(e) au moins partiellement d'une matière sacrificielle, la matière sacrificielle faisant preuve de propriétés anti-adhérentes par rapport à la matière de revêtement (2) alimentée avec le flux de mélange gazeux (8).

20. Procédé selon la revendication 19, **caractérisé en ce que** la matière sacrificielle comprend au moins un groupe acrylique (CH2=CB-COR), la part du groupe acrylique s'élevant de préférence à au moins 1 pour cent en poids de la matière sacrificielle.

21. Dispositif (1), destiné à appliquer une matière de revêtement (2) sur une surface (3a), pour réaliser le procédé selon l'une quelconque des revendications 1 à 20, comprenant
- un convoyeur de poudre (4), aménagé pour mettre à disposition un flux de mélange gazeux (8) comprenant un gaz porteur et une matière de revêtement (2),
- un organe d'alimentation (5), destiné à alimenter le flux de mélange gazeux vers la surface (3a), l'organe d'alimentation (5) étant aménagé de la sorte que le flux de mélange gazeux (8) soit incident sur la surface (3a) et que la matière de revêtement qui y est appliquée forme une zone d'incidence (11) sur la surface,
- un laser (6), destiné à générer un faisceau laser (7), aménagé pour injecter le faisceau laser (7) dans le flux de mélange gazeux (8),
- chaque faisceau laser (7) étant orienté par rapport au flux de mélange gazeux (8) de telle sorte que le faisceau laser (7) ne touche pas la zone d'incidence (11) sur la surface,
- un système de manutention, aménagé pour générer un déplacement relatif entre l'organe d'alimentation (5) et la surface (3a) à revêtir,
- des moyens destinés à interrompre temporairement l'injection du faisceau laser (7) dans le flux de mélange gazeux (8), à savoir
- par masquage du faisceau laser (7) à l'aide d'un écran, ou
- par déviation du faisceau laser (7) à l'aide d'une optique à laser, de telle sorte que le faisceau laser (7) ne soit temporairement pas orienté sur le mélange de flux gazeux (8).

22. Dispositif selon la revendication 21, **caractérisé en ce que**
- le système de manutention comporte un plateau tournant (24) rotatif autour d'un axe de rotation (23), qui est aménagé pour recevoir au moins un objet comportant la surface (3a) à revêtir,
- le système de manutention comporte un système linéaire (27) qui est aménagé pour générer un déplacement linéaire de l'organe d'alimentation (5) dans la direction d'un axe de translation (28),
- l'axe de translation (28) s'écoulant à la parallèle de l'axe de rotation (23).

23. Dispositif selon la revendication 22, **caractérisé en ce que** le laser (6) comporte une optique à laser aménagée pour orienter le faisceau laser (7) et/ou **en ce que** le laser (6) est placé sur un système de manutention aménagé pour l'orientation du faisceau laser (7).
